# EUROPÄISCHE PATENTSCHRIFT

(11) **EP 3 245 391 B1**
(45) Veröffentlichungstag und Bekanntmachung des Hinweises auf die Patenterteilung: **13.05.2020**
(21) Anmeldenummer: 16708587.7
(22) Anmeldetag: 11.01.2016
(51) Int. Cl.: F01L 1/16, C23C 14/58, B23K 26/00, F01L 1/18, B23K 26/359, B23K 26/352

(54) **VERFAHREN ZUR HERSTELLUNG EINES GLEITKONTAKTS SOWIE GLEITKONTAKT**
METHOD FOR PRODUCING A SLIDING CONTACT AND SLIDING CONTACT
PROCÉDÉ DE FABRICATION D'UN CONTACT GLISSANT ET CONTACT GLISSANT

(30) Priorität: 14.01.2015 DE 102015200476; 28.10.2015 DE 102015221041
(43) Veröffentlichungstag der Anmeldung: 22.11.2017
(73) Patentinhaber: Schaeffler Technologies AG & Co. KG, 91074 Herzogenaurach (DE)
(72) Erfinder: PÄTZOLD, Holger, 96138 Burgebrach (DE)
(86) Internationale Anmeldenummer: PCT/DE2016/200006
(87) Internationale Veröffentlichungsnummer: WO 2016/112904

(56) Entgegenhaltungen:
- EP-A2- 2 682 230
- DE-A1-102009 060 924
- US-A1- 2005 175 837

## Beschreibung

Die Erfindung betrifft ein Verfahren zur Herstellung eines Gleitkontakts, der aus einem Maschinenelement und mindestens einem weiteren Maschinenelement gebildet ist, wobei eine Gleitfläche an dem Maschinenelement, insbesondere einem Nockenfolger, wobei die Gleitfläche des Maschinenelements zum gleitenden Einsatz in Kontakt zu mindestens einem weiteren Maschinenelement vorgesehen ist, wobei das mindestens eine weitere Maschinenelement über die Gleitfläche in einer Gleitrichtung gleitet, wobei das Maschinenelement an zumindest einem Teil seiner Oberfläche zunächst mit einer Beschichtung versehen wird, in welche anschließend mittels Laserinterferenzstrukturieren eine Oberflächenstruktur eingebracht wird. Des Weiteren betrifft die Erfindung einen Gleitkontakt, der gemäß einem solchen Verfahren gebildet ist.

Aus der US 2005/0175837 A1 geht ein Verfahren zur Herstellung einer Gleitfläche an einem Maschinenelement hervor, wobei das Maschinenelement dabei an zumindest einem Teil seiner Oberfläche zunächst mit einer Beschichtung versehen wird. Im Anschluss daran wird mittels Laserstrukturieren eine Oberflächenstruktur in die Beschichtung eingebracht.

Die DE 10 2009 060 924 A1 beschreibt eine Struktur enthaltend einen Festschmierstoff für eine vakuumtribologische Anwendung. Dabei wird auf einer Substratbasis ein Schichtsystem umfassend eine Schicht aus diamantartigem Kohlenstoff (DLC) ausgebildet und im Schichtsystem oder in der Substratbasis und im Schichtsystem mittels eines Laserinterferenzverfahrens eine Vertiefungsstruktur ausgebildet, die mit einem Festschmierstoff gefüllt wird.

Weiterer relevanter Stand der Technik wird in den Dokumenten DE 10 2009 060924 A1, EP 2 682 230 A2 und US 2005/175837 A1 beschrieben. Ausgehend vom vorstehend beschriebenen Stand der Technik ist es nun die Aufgabe der vorliegenden Erfindung, ein Verfahren zur Herstellung eines verbesserten Gleitkontakts zu schaffen, wobei im Rahmen dieses Verfahrens auch bei niedrigen Schichtdicken einer Beschichtung eine Struktur eingebracht werden kann, welche die Beschichtung nicht durchdringt.

Diese Aufgabe wird ausgehend vom Oberbegriff des Anspruchs 1 in Verbindung mit dessen kennzeichnenden Merkmalen gelöst. Die hierauf folgenden, abhängigen Ansprüche geben jeweils vorteilhafte Weiterbildungen der Erfindung wieder.

Gemäß der Erfindung wird ein Verfahren zur Herstellung eines Gleitkontakts vorgeschlagen, der aus einem Maschinenelement und mindestens einem weiteren Maschinenelement gebildet ist, wobei eine Gleitfläche an einem Maschinenelement, insbesondere einem Nockenfolger, zum gleitenden Einsatz in Kontakt zu dem mindestens einen weiteren Maschinenelement vorgesehen ist, wobei das mindestens eine weitere Maschinenelement über die Gleitfläche in einer Gleitrichtung gleitet. Das Maschinenelement wird an zumindest einem Teil seiner Oberfläche zunächst mit einer Beschichtung versehen, in welche anschließend mittels Laserinterferenzstrukturieren eine Oberflächenstruktur eingebracht wird. Senkrecht auf eine Beschichtungsoberfläche der Beschichtung gesehen wird die Oberflächenstruktur umfassend eine Anzahl an in sich geschlossenen Strukturelementen ausgebildet. Eine Anzahl an Strukturelementen der Oberflächenstruktur wird in Bereichen der Gleitfläche umso höher ausgebildet, je höher eine Gleitgeschwindigkeit des mindestens einen weiteren Maschinenelements in diesem Bereich der Gleitfläche im Einsatz ist.

Es hat sich nämlich gezeigt, dass Gleitflächen mit besonders guten Gleiteigenschaften erzielt werden können, wenn ein in Verbindung damit eingesetzter flüssiger Schmierstoff mit der Oberflächenstruktur verzahnt und daran möglichst lange haften bleibt. Die Oberflächenstruktur muss demnach ein mit dem flüssigen Schmierstoff gefülltes Volumen bereitstellen und den Schmierstoff in Abhängigkeit der Last und der Geschwindigkeit des in Gleitrichtung darüber gleitenden weiteren Maschinenelements bereitstellen bzw. abgeben.

Es wurde erkannt, dass dabei von besonderer Bedeutung ist, in welcher Richtung die gleitende Beanspruchung der Gleitfläche erfolgt. Daher werden Strukturelemente gebildet, die bei einem Darübergleiten eines weiteren Maschinenelements einen Druck des Schmierstoffs im Volumen des Strukturelements erhöhen und - in Gleitrichtung gesehen - am Ende des Strukturelements den hydrostatischen Druck erhöhen und den Aufbau eines hydrodynamischen Schmierstoffpolsters ermöglichen.

Ein Strukturelement ist dabei erfindungsgemäß als "in sich geschlossen" anzusehen, wenn es senkrecht auf die Beschichtungsoberfläche gesehen an seinem Umfang von der Beschichtung umgeben ist, d.h. nicht mit dem Umfang der Beschichtung in Kontakt steht. Eine derartige Ausgestaltung der Strukturelemente stellt abgegrenzte, trogförmige Behältnisse zur Aufnahme des Schmiermittels bereit, so dass dieses nicht ohne weiteres daraus entweichen kann.

Insbesondere weist ein in sich geschlossenes Strukturelement senkrecht auf die Beschichtungsoberfläche gesehen eine Flächenausdehnung von maximal 10% der Gleitfläche auf. Dies gewährleistet, dass beim Gleiten eines weiteren Maschinenelements über die Gleitfläche an genügend Stellen der Gleitfläche hydrodynamische Schmiermittelpolster ausgebildet werden und eine Art "Aquaplaning"-Effekt zwischen den Gleitpartnern erzeugt wird.

Insbesondere werden die in sich geschlossenen Strukturelemente linienförmig als Linienabschnitte oder punktförmig als Mulden ausgebildet. Eine Länge der in sich geschlossenen, linienförmigen Strukturelemente wird bevorzugt im Bereich von etwa 20 µm bis 10 mm, insbesondere im Bereich von 20 µm bis 5 mm, gewählt. Punktförmige Strukturelemente werden insbesondere vorgesehen, wenn die Gleitfläche nicht nur dynamischen, sondern auch statischen Beanspruchungen ausgesetzt wird bzw. die Gleitgeschwindigkeit sehr klein oder gar Null werden kann.

Bevorzugt wird die Beschichtungsoberfläche parallel zur Gleitrichtung durch eine virtuelle Mittelline in zwei Hälften geteilt und Strukturelemente in Form von Linienabschnitten in einem Winkel γ ≠ 0 zur virtuellen Mittellinie ausgerichtet. Insbesondere werden die linienförmigen Strukturelemente in Gleitrichtung gesehen in dem Winkel γ ≠ 0 zur virtuellen Mittellinie hin zeigend ausgerichtet. Diese Maßnahmen begünstigen die Bildung der hydrodynamischen Schmierstoffpolster weiter.

Insbesondere bilden jeweils zwei der linienförmigen Strukturelemente ein V-förmiges Strukturgebilde, wobei eine Spitze dieses V-förmiges Strukturgebildes in die Gleitrichtung zeigend angeordnet wird. Dadurch wird der hydrodynamische Druck besonders erhöht, da das Schmiermittel aus den beiden linienförmigen Strukturelementen durch ein darübergleitendes Maschinenelement in den Bereich der Spitze des V gedrückt wird und dort besonders effektiv das hydrodynamische Schmierstoffpolster erzeugt.

Bevorzugt werden die Beschichtung und auch die Strukturierung an dem Maschinenelement dabei nur in Bereichen der Beschichtungsoberfläche vorgesehen, an welchen das Maschinenelement im späteren Einsatz gleitend mit anderen/weiteren Maschinenelementen in Kontakt tritt. Bei diesem Teil bzw. Teilen der Beschichtungsoberfläche oder ggf. auch der gesamten Beschichtungsoberfläche handelt es sich also um eine oder mehrere entsprechende Gleitflächen.

Im Allgemeinen wird mit Hilfe einer Beschichtung der Oberfläche des Maschinenelements mit einem geeigneten Material die Gleiteigenschaft verbessert, während mit Hilfe der Strukturierung gezielt Reservoirs für Schmiermittel geschaffen werden, über welche stets das Vorhandensein einer ausreichenden Schmiermittelmenge zwischen den Reibpartnern garantiert wird. Durch entsprechende Gestaltung dieser Struktur kann dabei ein Effekt ähnlich dem Aquaplaning-Effekt erzeugt werden, so dass der eine Reibpartner aufgrund der vorhandenen Schmiermittelmenge quasi auf dem anderen Reibpartner aufschwimmt.

Das Einbringen der Oberflächenstruktur wird mittels Laserinterferenzstrukturieren durchgeführt. Mit anderen Worten wird also das Laserstrukturieren konkret in Form von Laserinterferenzstrukturieren verwirklicht.

Ein derartiges Verfahren hat dabei den Vorteil, dass mit Hilfe des Laserinterferenzstrukturierens Mikrostrukturen mit geringer Tiefe ausgestaltet werden können, wobei diese Strukturen dabei exakt definiert und periodisch aufeinanderfolgend bei gleichzeitig niedrigen Fertigungszeiten fertigbar sind. Dadurch, dass mittels des Laserinterferenzstrukturierens sehr geringe Strukturtiefen realisierbar sind, kann somit eine Gleitfläche hergestellt werden, bei welcher eine Beschichtung auch bei geringer Schichtdicke nicht durch eine Oberflächenstruktur durchdrungen wird. Beim Laserinterferenzstrukturieren werden auf dem Fachmann bekannte Art und Weise mehrere Laserstrahlen zur gemeinsamen Ausgestaltung der jeweiligen Strukturierung genutzt.

Bei Anwendung eines klassischen Laserstrukturierungsverfahrens lassen sich keine sehr geringen Strukturtiefen fertigen, was bei geringen Schichtdicken der Beschichtung zu einem Durchdringen der Beschichtung führt. Generell sind hierdurch die Freiheitsgrade bezüglich der Abstimmung der Beschichtung und der Strukturierung aufeinander begrenzt.

Entsprechend einer Ausführungsform der Erfindung beträgt eine Tiefe einer eingebrachten Oberflächenstruktur im Verhältnis zu einer Schichtdicke der Beschichtung 0,5. Hierdurch kann ein geeignetes Zusammenspiel der Beschichtung mit der Oberflächenstruktur verwirklicht werden.

In Weiterbildung der Erfindung wird als Beschichtung eine Chrom-Nickel-Schicht (CrNi-Schicht) oder eine Schicht aus amorphem Kohlenstoff aufgebracht, so dass sich geeignete Gleiteigenschaften des Maschinenelements in dem entsprechenden Bereich seiner Oberfläche verwirklichen lassen. Prinzipiell können jedoch im Rahmen der Erfindung auch anderweitige Beschichtungen auf der Oberfläche des Maschinenelements vorgesehen werden.

Dabei können neben einer amorphen Kohlenstoffschicht (DLC) auch mehrere amorphe Kohlenstoffschichten (DLC) aufgebracht sein. Weiterhin können eine oder mehrere Hartstoffschichten aus Nitriden, Karbiden, Oxiden, hier auch als Mischformen und / oder als Multilagen, aufgebracht sein. Auch das Aufbringen einer Beschichtung in Form einer oder mehrerer Hartchromschichten, Mangan- und/oder Zinkphosphatschichten, Metallsulfidschichten, Graphitschichten, PTFE-Schichten sowie einer Brünierungsschicht hat sich bewährt.

Es ist eine weitere Ausgestaltungsmöglichkeit der Erfindung, dass die Gleitfläche eines Nockenfolgers, insbesondere eines Tassenstößels, eines Schlepphebels, eines Pumpenstößels oder Ähnliches hergestellt wird. So kann es sich bei dem Nockenfolger um einen Tassenstößel oder auch einen hebelartigen Nockenfolger für ein Ventiltriebssystem einer Brennkraftmaschine oder aber auch um eine Komponente einer Pumpe handeln. Darüber hinaus kann das erfindungsgemäße Verfahren auch zur Herstellung einer Gleitfläche an einem Kettenbolzen zur Anwendung kommen.

Gemäß der Erfindung wird die Oberflächenstruktur ungleichmäßig ausgestaltet. Diese Ungleichmäßigkeit kann dabei durch Vorsehen unterschiedlicher Strukturtiefen und/oder Vorsehen unterschiedlicher Strukturgeometrien und/oder eine unterschiedliche Dichte an Strukturen verwirklicht sein, so dass an der Oberfläche des Maschinenelements eine Anpassung der Gleitfläche an unterschiedliche, im Betrieb auftretende Gleitgeschwindigkeiten möglich ist. So werden in einem Bereich der Oberfläche dort eine größere Anzahl an Strukturelementen vorgesehen, wo höhere Gleitgeschwindigkeiten auftreten und daher mehr Schmiermittel vorzuhalten ist. Besonders bevorzugt wird die Strukturtiefe der Oberflächenstruktur im Bereich eines in sich geschlossenen Strukturelements unterschiedlich ausgestaltet, um den Druckaufbau zur Bildung des Schmiermittelpolsters innerhalb des Strukturelements noch zu unterstützen.

Es ist eine weitere bevorzugte Ausgestaltungsmöglichkeit der Erfindung, dass die Beschichtung mit einer Schichtdicke von 0,05 bis 6 µm ausgebildet wird, in welche die Oberflächenstruktur mit einer Tiefe von 0,01 µm bis 0,4 µm eingebracht wird. Prinzipiell ist aber auch ein tieferes Strukturieren bis 30 µm oder auch tiefer möglich, sofern dies im Einzelfall technisch sinnvoll ist. Generell wird durch das Vorsehen einer geringeren Strukturtiefe im Vergleich zur Schichtdicke ein Halten des Schmiermittels auf der Beschichtungsoberfläche verwirklicht.

Ein Gleitkontakt hat sich bewährt, der nach dem erfindungsgemäßen Verfahren gebildet ist, wobei die Gleitfläche des Maschinenelements zum gleitenden Einsatz in Kontakt zu dem mindestens einem weiteren Maschinenelement vorgesehen ist, wobei das mindestens eine weitere Maschinenelement zum Gleiten über die Gleitfläche in einer Gleitrichtung mit über die Gleitfläche gesehen unterschiedlichen, im Betrieb auftretenden Geschwindigkeiten vorgesehen ist, und wobei die Gleitfläche mit einem insgesamt flüssigen Schmiermittel versehen ist.
Dabei wird insbesondere ein flüssiges Schmiermittel in Form von Öl, insbesondere der SAE-Kennung 0W-x, oder ein Dieselkraftstoff eingesetzt. Je kleiner der eingesetzte Wert für den Buchstaben x in der SAE-Kennung 0W-x gewählt ist, desto dünnflüssiger ist das Schmiermittel.

Die Erfindung ist durch den Gegenstand der Ansprüche definiert. Die Bezugnahme der Ansprüche auf die Zeichnung durch Verwendung von Bezugszeichen soll den Schutzumfang der Ansprüche nicht beschränken. So zeigt:
- FIG 1: ein Maschinenelement im Schnittbild; und
- FIG 2: eine dreidimensionale Ansicht eines Maschinenelements in Form eines Schlepphebels.

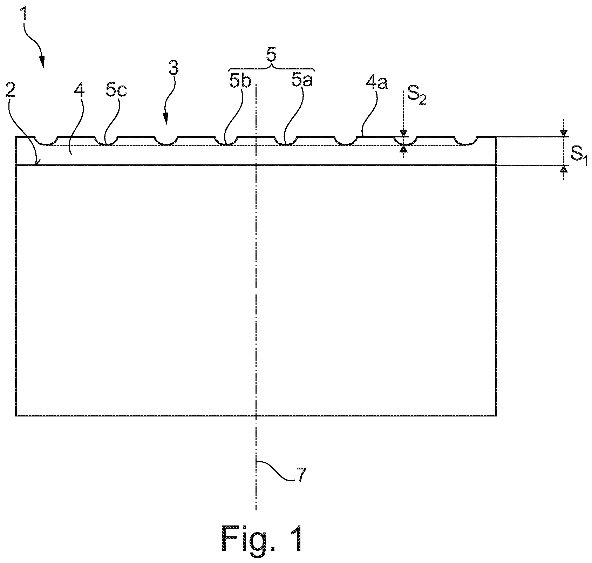

Die Figur 1 zeigt einen Teil eines Maschinenelements 1 in Schnittdarstellung, wobei es sich bei diesem Maschinenelement 1 um einen Nockenfolger, wie beispielsweise einen Tassenstößel, einen Schlepphebel oder Ähnliches handelt. An seiner Oberfläche 2 ist das Maschinenelement 1 mit einer Gleitfläche 3 für den Kontakt mit einem weiteren, hier nicht dargestellten Maschinenelement ausgestattet, wobei zur Ausgestaltung der Gleitfläche 3 zunächst eine Beschichtung 4 auf die Oberfläche 2 aufgebracht wurde.

Vorliegend weist die Beschichtung 4, bei welcher es sich um eine Chrom-Nickel-Schicht oder auch eine Schicht aus amorphem Kohlenstoff handeln kann, eine Beschichtungsoberfläche 4a und eine Schichtdicke s₁ auf, die im Bereich von 0,05 bis 1,2 µm liegt. Im Anschluss an die Beschichtung 4 wurde dann eine Oberflächenstruktur 5 in die Beschichtungsoberfläche 4a eingebracht, wobei diese Strukturierung mittels Laserinterferenzstrukturieren hergestellt wurde. Dabei werden in sich geschlossene Strukturelemente 5a, 5b, 5c durch Zusammenspiel mehrerer Laserstrahlen ausgestaltet, wobei eine Strukturtiefe s₂ der Oberflächenstruktur 5 dabei im Bereich von 0,15 bis 0,4 µm liegt. Insofern wird die Beschichtung 4 nicht durch die Oberflächenstruktur 5 durchdrungen. Mit Hilfe des Laserinterferenzstrukturierens kann dies auch bei geringen Schichtdicken s₁ verwirklicht werden. Das Bezugszeichen 7 kennzeichnet eine virtuelle Mittellinie 7 der Gleitfläche 3.

Mittels eines erfindungsgemäßen Verfahrens zur Herstellung einer Gleitfläche können somit Oberflächenstrukturen an einer Beschichtung eines Maschinenelements ausgestaltet werden, ohne dass die Beschichtung hierbei durchdrungen wird.

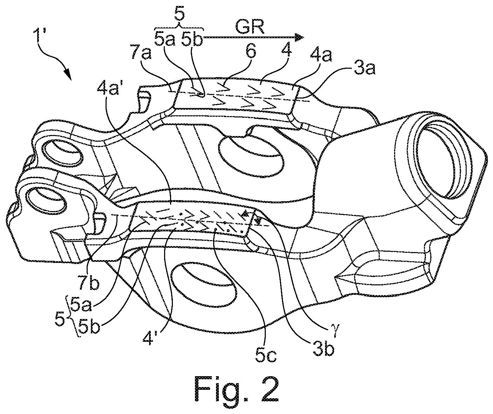

Figur 2 zeigt eine dreidimensionale Ansicht eines Maschinenelements 1' in Form eines Schlepphebels mit zwei Gleitflächen 3a, 3b. Die Gleitflächen 3a, 3b des Maschinenelements 1' sind zum gleitenden Einsatz in Kontakt zu mindestens einem weiteren, hier nicht dargestellten Maschinenelement vorgesehen, wobei das mindestens eine weitere Maschinenelement über die Gleitflächen 3a, 3b in einer Gleitrichtung GR gleitet. Das Maschinenelement 1' ist in zwei Bereichen seiner Oberfläche 2 (vergleiche Figur 1) mit jeweils einer Beschichtung 4, 4' versehen, in welche anschließend mittels Laserinterferenzstrukturieren eine Oberflächenstruktur 5 umfassend linienförmige Strukturelemente 5a, 5b sowie punktförmige Strukturelemente 5c eingebracht werden.

Dabei ist senkrecht auf eine Beschichtungsoberfläche 4a, 4a' der Beschichtung 4, 4' gesehen die jeweilige Beschichtungsoberfläche 4a, 4a' parallel zur Gleitrichtung GR durch eine virtuelle Mittelline 7a, 7b in zwei Hälften geteilt. Die Oberflächenstruktur 5 ist umfassend eine Anzahl an linienförmigen Strukturelementen 5a, 5b ausgebildet, die in einem Winkel γ ≠ 0 zur virtuellen Mittellinie 7a, 7b ausgerichtet sind. Dabei bilden mehrere der linienförmigen Strukturelemente 5a, 5b in paarweiser Anordnung ein V-förmiges Strukturgebilde 6, wobei eine Spitze dieses V-förmiges Strukturgebildes 6 in die Gleitrichtung GR zeigend angeordnet ist.
Dadurch wird der hydrodynamische Druck eines insgesamt flüssigen Schmiermittels, das auf die Gleitflächen 3a, 3b aufgetragen wird, besonders erhöht, da das Schmiermittel aus den beiden linienförmigen Strukturelementen 5a, 5b durch ein darübergleitendes Maschinenelement in den Bereich der Spitze des V gedrückt wird und dort besonders effektiv das hydrodynamische Schmierstoffpolster erzeugt.

### Bezugszeichenliste

- 1,1': Maschinenelement
- 2: Oberfläche
- 3,3a,3b: Gleitfläche
- 4,4': Beschichtung
- 4a,4a': Beschichtungsoberfläche
- 5: Oberflächenstruktur
- 5a,5b,5c: Strukturelement
- 6: Strukturgebilde
- 7,7a,7b: virtuelle Mittellinie
- s₁: Schichtdicke
- s₂: Strukturtiefe

## Patentansprüche

1. Verfahren zur Herstellung eines Gleitkontakts, der aus einem Maschinenelement (1, 1') und mindestens einem weiteren Maschinenelement gebildet ist, wobei eine Gleitfläche (3, 3a, 3b) an dem Maschinenelement (1, 1'), insbesondere einem Nockenfolger, zum gleitenden Einsatz in Kontakt zu dem mindestens einen weiteren Maschinenelement vorgesehen ist, wobei das mindestens eine weitere Maschinenelement über die Gleitfläche (3, 3a, 3b) in einer Gleitrichtung (GR) gleitet, wobei das Maschinenelement (1, 1') an zumindest einem Teil seiner Oberfläche (2) zunächst mit einer Beschichtung (4, 4') versehen wird, in welche anschließend mittels Laserinterferenzstrukturieren eine Oberflächenstruktur (5) eingebracht wird, wobei senkrecht auf eine Beschichtungsoberfläche (4a, 4a') der Beschichtung (4, 4') gesehen die Oberflächenstruktur (5) umfassend eine Anzahl an in sich geschlossenen Strukturelementen (5a, 5b, 5c) ausgebildet wird, **dadurch gekennzeichnet, dass** eine Anzahl an Strukturelementen (5a, 5b, 5c) der Oberflächenstruktur (5) in Bereichen der Gleitfläche (3, 3a, 3b) umso höher ausgebildet wird, je höher eine Gleitgeschwindigkeit des mindestens einen weiteren Maschinenelements in diesem Bereich der Gleitfläche (3, 3a, 3b) im Einsatz ist.

2. Verfahren nach Anspruch 1, wobei ein jedes, in sich geschlossenes Strukturelement (5a, 5b, 5c) senkrecht auf die Beschichtungsoberfläche (4a, 4a') gesehen in einer Flächenausdehnung von maximal 10% der Gleitfläche (3, 3a, 3b) ausgebildet wird.

3. Verfahren nach Anspruch 1 oder Anspruch 2, wobei die in sich geschlossenen Strukturelemente (5a, 5b, 5c) linienförmig als Linienabschnitte oder punktförmig als Mulden ausgebildet werden.

4. Verfahren nach einem der Ansprüche 1 bis 3, wobei die Beschichtungsoberfläche (4a, 4a') parallel zur Gleitrichtung (GR) durch eine virtuelle Mittelline (7, 7a, 7b) in zwei Hälften geteilt und Strukturelemente (5a, 5b) in Form von Linienabschnitten in einem Winkel γ ≠ 0 zur virtuellen Mittellinie (7, 7a, 7b) ausgerichtet werden.

5. Verfahren nach Anspruch 4, wobei jeweils zwei der linienförmigen Strukturelemente (5a, 5b) ein V-förmiges Strukturgebilde (6) bilden, wobei eine Spitze dieses V-förmiges Strukturgebildes (6) in die Gleitrichtung (GR) zeigend angeordnet wird.

6. Verfahren nach einem der Ansprüche 1 bis 5, wobei eine Strukturtiefe (s₂) der eingebrachten Oberflächenstruktur (5) im Verhältnis zu einer Schichtdicke (s₁) der Beschichtung (4, 4') 0,5 beträgt.

7. Verfahren nach einem der Ansprüche 1 bis 6, wobei als Beschichtung (4, 4') eine CrNi-Schicht oder eine Schicht aus amorphem Kohlenstoff aufgebracht wird.

8. Verfahren nach einem der Ansprüche 1 bis 7, wobei die Gleitfläche (3, 3a, 3b) eines Nockenfolgers, insbesondere eines Tassenstößels, eines Schlepphebels oder eines Pumpenstößels, hergestellt wird.

9. Verfahren nach einem der Ansprüche 1 bis 8, wobei die Oberflächenstruktur (5) über die Gleitfläche (3, 3a, 3b) gesehen ungleichmäßig ausgestaltet wird, indem unterschiedliche Strukturtiefen und/oder unterschiedliche Strukturgeometrien und/oder eine unterschiedliche Dichte an Strukturen verwirklicht ist/sind.

10. Verfahren nach Anspruch 9, wobei die Strukturtiefe der Oberflächenstruktur (5) im Bereich eines in sich geschlossenen Strukturelements (5a, 5b, 5c) unterschiedlich ausgestaltet wird.

11. Verfahren nach einem der Ansprüche 1 bis 10, wobei die Beschichtung (4) der mindestens einen Gleitfläche (3, 3a, 3b) mit einer Schichtdicke (s₁) im Bereich von 0,05 bis 6 µm ausgebildet wird, in welche die Oberflächenstruktur (5) mit einer Strukturtiefe (s₂) im Bereich von 0,01 bis 0,4 µm, insbesondere im Bereich von 0,15 bis 0,4 µm, eingebracht wird.

12. Gleitkontakt, der gemäß einem Verfahren nach einem der Ansprüche 1 bis 11 gebildet ist, wobei die Gleitfläche (3, 3a, 3b) des Maschinenelements (1, 1') zum gleitenden Einsatz in Kontakt zu dem mindestens einem weiteren Maschinenelement vorgesehen ist, wobei das mindestens eine weitere Maschinenelement zum Gleiten über die Gleitfläche (3, 3a, 3b) in einer Gleitrichtung (GR) mit über die Gleitfläche (3, 3a, 3b) gesehen unterschiedlichen, im Betrieb auftretenden Gleitgeschwindigkeiten vorgesehen ist, und wobei die Gleitfläche (3, 3a, 3b) mit einem insgesamt flüssigen Schmiermittel versehen ist.

## Claims

1. A method for producing a sliding contact which is formed from a machine element (1, 1 ') and at least one further machine element, wherein a sliding surface (3, 3a, 3b) is provided on the machine element (1, 1'), in particular a cam follower, for sliding use in contact with the at least one further machine element, the at least one further machine element sliding over the sliding surface (3, 3a, 3b) in a sliding direction (SD), wherein the machine element (1, 1'), on at least part of its surface (2), is first provided with a coating (4, 4 '), into which a surface structure (5) is subsequently introduced by means of laser interference structuring, wherein, when viewed perpendicularly to a coating surface (4a, 4a') of the coating (4, 4 '), the surface structure (5) comprising a number of self-contained structural elements (5a, 5b, 5c) is formed, **characterised in that** a higher number of structural elements (5a, 5b, 5c) of the surface structure (5) is provided in areas of the sliding surface (3, 3a, 3b), the higher a sliding speed used for the at least one further machine element in this area of the sliding surface (3, 3a, 3b).

2. The method according to claim 1, wherein each self-contained structural element (5a, 5b, 5c), viewed perpendicularly to the coating surface (4a, 4a'), is formed with a surface area of at most 10% of the sliding surface (3, 3a, 3b).

3. The method according to claim 1 or claim 2, wherein the self-contained structural elements (5a, 5b, 5c) are formed linearly as line sections or in point form as depressions.

4. The method according to any one of claims 1 to 3, wherein the coating surface (4a, 4a') parallel to the sliding direction (SD) is divided in half by a virtual centre line (7, 7a, 7b), and structural elements (5a, 5b) in the form of line sections are aligned at an angle γ ≠ 0 to the virtual centre line (7, 7a, 7b).

5. The method according to claim 4, wherein two each of the linear structural elements (5a, 5b) form a V-shaped structural arrangement (6), a tip of this V-shaped structural arrangement (6) being arranged pointing in the sliding direction (SD).

6. The method according to any one of claims 1 to 5, wherein the ratio of the structural depth (s₂) of the introduced surface structure (5) to a layer thickness (s₁) of the coating (4, 4') is 0.5.

7. The method according to any one of claims 1 to 6, wherein a CrNi layer or a layer of amorphous carbon is applied as the coating (4, 4').

8. The method according to any one of claims 1 to 7, wherein the sliding surface (3, 3a, 3b) of a cam follower, in particular a cup tappet, a rocker arm or a pump tappet, is produced.

9. The method according to any one of claims 1 to 8, wherein the surface structure (5), viewed over the sliding surface (3, 3a, 3b), is given a non-uniform configuration by realizing different structural depths and/or different structural geometries and/or a different structural density.

10. The method of claim 9, wherein the structural depth of the surface structure (5) in the area of a self-contained structural element (5a, 5b, 5c) is configured differently.

11. The method according to any one of claims 1 to 10, wherein the coating (4) of the at least one sliding surface (3, 3a, 3b) is formed with a layer thickness (s₁) in the range of from 0.05 to 6 µm, into which the surface structure (5) with a structural depth (s₂) in the range from 0.01 to 0.4 µm, in particular in the range from 0.15 to 0.4 µm, is introduced.

12. A sliding contact, which is formed according to a method according to any one of claims 1 to 11, wherein the sliding surface (3, 3a, 3b) of the machine element (1, 1') is provided for sliding use in contact with the at least one further machine element, wherein the at least one further machine element is provided for sliding over the sliding surface (3, 3a, 3b) in a sliding direction (SD) with different sliding speeds occurring during operation, viewed over the sliding surface (3, 3a, 3b), and wherein the sliding surface (3, 3a, 3b) is provided with an overall liquid lubricant.

## Revendications

1. Procédé de fabrication d'un contact glissant qui est formé d'un élément de machine (1, 1') et d'au moins un autre élément de machine, une surface de glissement (3, 3a, 3b) étant prévue sur l'élément de machine (1, 1'), en particulier un suiveur de came, pour un contact par glissement avec ledit autre élément de machine, ledit autre élément de machine glissant sur la surface de glissement (3, 3a, 3b) dans une direction de glissement (GR), l'élément de machine (1, 1') étant pourvu sur au moins une partie de sa surface (2) dans un premier temps d'un revêtement (4, 4'), dans lequel une structure de surface (5) étant introduite dans un second temps au moyen d'une structuration par interférence laser, vue perpendiculairement à une surface de revêtement (4a, 4a') du revêtement (4, 4') se forme la structure de surface (5) comprenant un certain nombre d'éléments structuraux fermés sur eux-mêmes (5a, 5b, 5c), **caractérisé en ce que** plus le nombre d'éléments structuraux (5a, 5b, 5c) de la structure de surface (5) dans les zones de la surface de glissement (3, 3a, 3b) est élevé, plus la vitesse de glissement dudit autre élément de machine dans cette zone de la surface de glissement (3, 3a, 3b) est élevée lors de l'utilisation.

2. Procédé selon la revendication 1, selon lequel chaque élément structural fermé sur lui-même (5a, 5b, 5c) est formé perpendiculairement à la surface de revêtement (4a, 4a'), sa dimension surfacique étant inférieure ou égale à 10 % de la surface de glissement (3, 3a, 3b).

3. Procédé selon la revendication 1 ou la revendication 2, selon lequel les éléments structuraux fermés sur eux-mêmes (5a, 5b, 5c) sont formés linéairement en sections de ligne ou en forme de point en creux.

4. Procédé selon l'une quelconque des revendications 1 à 3, selon lequel la surface de revêtement (4a, 4a') parallèle à la direction de glissement (GR) est divisée par une ligne médiane virtuelle (7, 7a, 7b) en deux et des éléments structuraux (5a, 5b) sont alignés sous la forme de segments de ligne selon un angle γ ≠ 0 par rapport à la ligne médiane virtuelle (7, 7a, 7b).

5. Procédé selon la revendication 4, selon lequel deux des éléments structuraux linéaires (5a, 5b) forment une structure en forme de V (6), une pointe de cette structure en forme de V (6) étant disposée pointant dans la direction de glissement (GR).

6. Procédé selon l'une quelconque des revendications 1 à 5, selon lequel une profondeur de structure (s₂) de la structure de surface introduite (5) par rapport à une épaisseur de couche (s₁) du revêtement (4, 4') est de 0,5.

7. Procédé selon l'une quelconque des revendications 1 à 6, selon lequel une couche de CrNi ou une couche de carbone amorphe est appliquée comme revêtement (4, 4').

8. Procédé selon l'une quelconque des revendications 1 à 7, selon lequel la surface de glissement (3, 3a, 3b) d'un suiveur de came, en particulier un poussoir à coupelle, un culbuteur ou un poussoir de pompe, est fabriquée.

9. Procédé selon l'une quelconque des revendications 1 à 8, selon lequel la structure de surface (5) vue sur la surface de glissement (3, 3a, 3b) est conçue pour être non uniforme par la réalisation de différentes profondeurs de structure et/ou de différentes géométries de structure et/ou une densité de structures différente.

10. Procédé selon la revendication 9, selon lequel la profondeur de structure de la structure de surface (5) dans la zone d'un élément de structure fermé sur lui-même (5a, 5b, 5c) est conçue différemment.

11. Procédé selon l'une quelconque des revendications 1 à 10, selon lequel est formé le revêtement (4) de ladite surface de glissement (3, 3a, 3b) dont l'épaisseur de couche (s₁) est comprise dans la plage entre 0,05 et 6 µm, dans laquelle est insérée la structure de surface (5) dont la profondeur de structure (s₂) est comprise dans la plage entre 0,01 et 0,4 µm, notamment dans la plage entre 0,15 et 0,4 µm.

12. Contact glissant, qui est formé selon un procédé selon l'une quelconque des revendications 1 à 11, selon lequel la surface de glissement (3, 3a, 3b) de l'élément de machine (1, 1') est destinée à être utilisée pour un contact par glissement avec ledit autre élément de machine, ledit autre élément de machine étant destiné à glisser sur la surface de glissement (3, 3a, 3b) dans une direction de glissement (GR) à différentes vitesses de glissement pendant le fonctionnement sur la surface de glissement (3, 3a, 3b) et un lubrifiant liquide étant appliqué sur toute la surface de glissement (3, 3a, 3b).
